# EUROPEAN PATENT SPECIFICATION

(11) **EP 2 481 980 B1**
(45) Date of publication and mention of the grant of the patent: **13.04.2016**
(21) Application number: 12000620.0
(22) Date of filing: 31.01.2012
(51) Int. Cl.: F21V 19/00, F21V 29/00, F21K 99/00, F21S 2/00, H05K 1/02, F21V 29/77, F21V 29/75, F21Y 115/10, F21V 17/16

(54) **LED lamp**
LED-Lampe
Lampe à DEL

(30) Priority: 01.02.2011 IT TO20110084; 09.08.2011 IT TO20110756
(43) Date of publication of application: 01.08.2012
(73) Proprietor: GS Plastics s.a.s di Giovanni Gervasio & C., 10091 Alpignano (DE)
(72) Inventor: Gervasio, Giovanni, 10091 Alpignano ( TO) (IT)
(74) Representative: Aprà, Mario

(56) References cited:
- EP-A1- 1 139 019
- WO-A1-2007/078103
- CN-A- 101 198 216
- DE-A1- 19 736 962
- US-A1- 2005 024 834
- US-A1- 2006 289 887
- US-A1- 2008 192 462

## Description

The present invention relates to a LED lamp.

A lamp of the type specified comprises at least one LED (called power LED), which basically includes a light-emitting chip with lens, two pins or terminals, namely an anode and a cathode, for electrical connection of the same chip, and a metal plate (hereafter called "thermal pad") for dissipating the heat produced during operation. In a conventional LED lamp, the two pins of each LED are fixed to respective moulded copper pads for electrical connection to paths of electrically conductive material and which produce an electric printed circuit, provided in a support made of electrically insulating material. In this way, one or more LEDS can be connected in series or in parallel to an electrical power source. In some cases, the thermal pad is connected electrically to the anode or to the cathode of the LED, while in other cases it is isolated. In any case, the thermal pad in mechanically connected soldered on a copper pad or track provided in said support for dissipating the heat produced by the LED. This copper track is in turn connected to an underlying intermediate layer made of thermally conductive material, but electrically insulating and isolated, such as ceramic, prepreg or plastic material. Fixed under the intermediate layer of thermally conductive material is a metal heat accumulating plate, for example made of aluminium, which is both thermally and electrically conductive, which acts as heat accumulator and distributor, approximate 0. - 1.6 mm thick. The surface of the accumulator plate opposite the one facing the circuits is rough and not ground with perfect planarity. It must be noted that in place of aluminium, said accumulator plate can be made of CEM-3, which is a heat-conducting resin. In this case, the ceramic or prepreg intermediate layer is not provided, as CEM-3 is electrically insulating.

A heat dissipating device, also having a rough joining surface, is fixed to the rough surface of said accumulator plate and using appropriate means of the known LED lamp thus produced.

Advantageously, an appropriate thermally conductive compensation medium, such as a heat conducting paste or an adhesive tape or double-sided adhesive tape, is interposed between said two opposed rough surfaces to make the same surfaces even. This arrangement produces the best thermal conduction between opposed surfaces and therefore allows the maximum amount of heat to be removed from the heat accumulator plate.

Document EP 1 139 019 A1 shows a LED lamp comprising at least one LED, which basically includes a light-emitting chip with lens, two terminals, namely an anode and a cathode, for electrical connection of the same chip, and a metal plate (hereafter called thermal pad) for dissipating the heat produced during operation, wherein the two terminals of said at least one LED are electrically connected to at least one track of electrically conductive material in a support made of electrically insulating material of a printed circuit.

The thermal pad of said at least one LED is directly connected to a plate or sheet heat dissipator (hereinafter said "heat sink") made of good thermal conductive material so as to disperse the heat produced by thermal conduction also through said same plate or sheet heat sink.

However, the arrangement described above of means for dissipating the heat produced by the LED or by the LEDs gives rise to numerous problems of the respective lamp, including:
- considerable weight and overall dimension, with consequent high transport costs;
- important costs of the materials of the accumulator plate and of the heat sink device, and of the ceramic material, of the prepreg, of the thermal conductive paste or thermal conductive adhesive or double-sided adhesive tape;
- important costs for mechanical machining and for assembly of the aforesaid parts.

The present invention intends to solve the problems set forth above.

The object of the invention is to provide a LED lamp with reduced weight and overall dimension and with limited technical and economic costs both in terms of materials and machining for its production.

Another object of the invention is to provide a LED lamp with a simplified structure, which is safe and reliable to operate and easy to maintain.

Yet another object of the invention is to provide a LED lamp which can be produced in various forms and regardless of the shape of the electronic printed circuit for connection and supply of the LED or LEDs.

A further object of the invention is to provide a LED lamp which can be produced using standardized components so as to allow simplification of the production process.

A further object of the invention is to provide a LED lamp which has good electrical insulation and water-resistance properties and has a simplified structure, is safe and reliable to operate and easy to maintain.

In view of these objects, the present invention provides a LED lamp, the main characteristic of which is indicated in claim 1. Further advantageous characteristics are indicated in the dependent claims.

The present invention will be more apparent from the detailed description below, with reference to the accompanying drawing, provided purely by way of example, wherein:
- Figs. 1 and 2 respectively show, in a perspective and schematic view, two different examples of power LEDs, which can be used in the LED lamp according to the present invention;
- Fig. 3 is a schematic and partial perspective view of the internal structure with electronic printed circuit and LED of a first embodiment of the LED lamp according to the invention;
- Fig. 4 is a similar view to that of Fig. 3, but complete and in a different scale;
- Fig. 5 is a perspective and schematic view of the internal structure with electronic printed circuit and LEDs of a second embodiment of the LED lamp according to the invention;
- Fig. 6 is a detailed view, in a larger scale, of the detail VI of Fig. 4;
- Figs. 7 and 8 are perspective and schematic views, respectively from the top and from the bottom, of the internal structure with electronic printed circuit and LEDs of a third embodiment of the LED lamp according to the invention;
- Fig. 9 is a perspective view of the internal structure with electronic printed circuit and LEDs of a fourth embodiment of the LED lamp according to the invention;
- Fig. 10 is a partial perspective view of a LED lamp according to an example of embodiment of the invention, which shows a single modular power LED lighting component mounted on a plate support, only partly shown;
- Figs. 11 and 12 are views similar to that of Fig. 10, but showing, in a larger scale, only said modular lighting component, which in Fig. 12 is shown in a partial cutaway view;
- Fig. 13 is a perspective view, in a different scale, of a lighting unit comprising an electronic printed circuit with electrical connection cables, a power LED and a heat sink of the aforesaid modular component according to Fig. 10;
- Figs. 14 and 15 are perspective views, in a different scale, of two parts, respectively bottom and cover, of a modular enclosure of said modular component according to Fig. 10;
- Fig. 16 is a similar view to that of Fig. 11, but in which said modular lighting component also comprises a lens;
- Fig. 17 is a perspective view, in a different scale, of two lighting units of two modular components similar to the one according to Fig. 11, connected electrically to each other and without their respective enclosures for clarity of illustration.

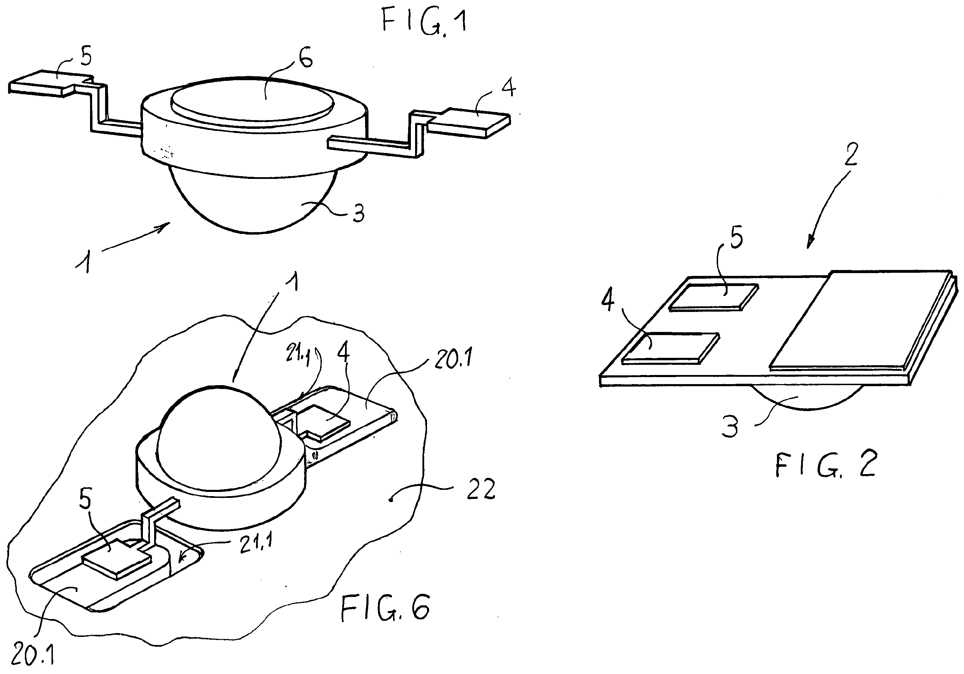

With reference to the drawing, Figs. 1 and 2 show two examples of power LEDs 1, 2 respectively, which can be used for example in a LED lamp according to the invention. The LEDs 1, 2 each comprise a light-emitting chip with lens 3, an anode 4 and a cathode 5, and a thermal pad 6.

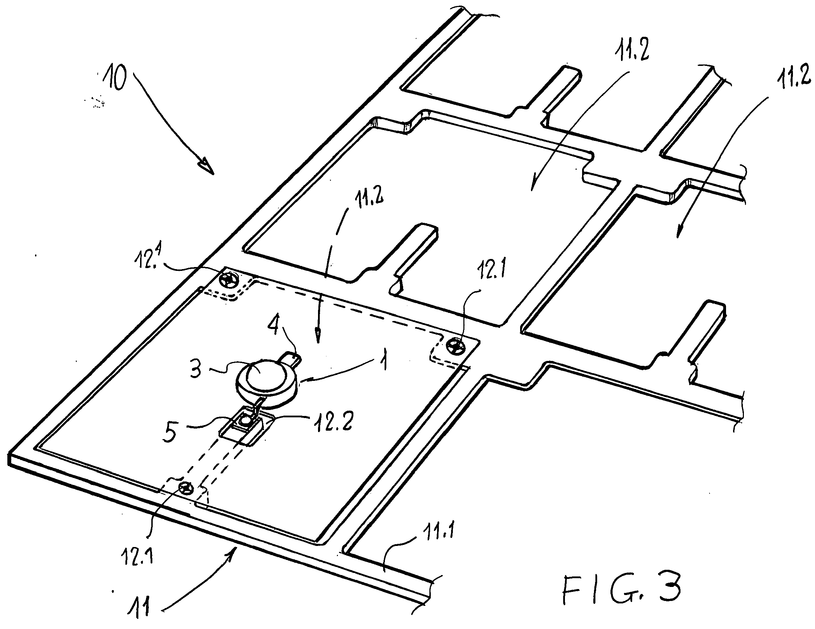

With reference to Fig. 3, the number 10 indicates as a whole the internal structure with electronic printed circuit and LED of a first example of embodiment of a LED lamp according to the invention, of which the external containing enclosure is not shown, as it is not of interest for the purposes of the description.

Said lamp 10 basically includes:
- an electronic printed circuit 11, which conventionally includes both tracks (not visible in detail in the drawing) for electrical connection between the various electronic components and which constitute a proper electrical circuit, and a mechanical support 11.1 for said tracks and for said components and respective accessories, which forms a structure, for example rigid, in which each component has a predefined geometrical position. In particular, said mechanical support 11.1 is made of an electrically insulating but thermally conductive material, such as CEM-3, and is structured in the shape of a flat frame having open quadrangular cells 11.2. The support 11.1 can also be made, for example, of FR-4, which is not thermally conductive;
- a plurality of thin quadrangular plate or foil heat dissipators (hereinafter said "heat sinks") 12 (only one of which is represented) made of good thermal conductive material, such as copper. Each heat sink 12 is superimposed on said printed circuit 11 at a respective open cell 11.2, so as to rest with its peripheral fixing areas 12.1 (three in the example) on respective electrically conductive pads of said electronic printed circuit 11, while corresponding soldering points applied in said areas 12.1 produce the mechanical fixing and electrical connection of said heat sink 12, for example, to the anode of said electrical circuit;
- a plurality of power LEDs 1 (only one of which is represented), which by means of the respective thermal pad 6 (not visible in this figure) are soldered directly (with solder of known type) on a corresponding thin plate or foil heat sink 12, so that the same LED is also connected electrically, by means of said foil heat sink 12, with its anode 4 to the anode of said electronic printed circuit 11 at the fixing points 12.1 of the heat sink 12. On the other hand, the cathode 5 of said LED 1 is connected electrically, through a corresponding opening 12.2 of the foil heat sink 12 and by means of a respective soldering point, to the anode of the electrical power supply of said circuit (known *per* se and not shown) or of another LED 1 connected in the same circuit.

By means of the aforesaid arrangement, the heat produced by each LED 1 of the lamp 10 is transmitted directly by thermal conduction, in a significant amount, to the individual foil heat sink 12 which dissipates it into the surrounding atmosphere through its two free radiant surfaces and through the open cells 11.2 of said electronic printed circuit 11. On the other hand, the support 11.1 of the printed circuit 11 can, as stated, also be made of thermally conductive material (CEM-3) and also help to dissipate a residual amount of heat into the surrounding atmosphere.

The technical form and the structure of the container (not shown) of the lamp with internal structure 10, which do not fall within the scope of the invention, is in any case such as to facilitate or at least not to obstruct thermal dispersion of the heat produced by the LED 1 by means of said foil heat sinks 12 and the support 11.

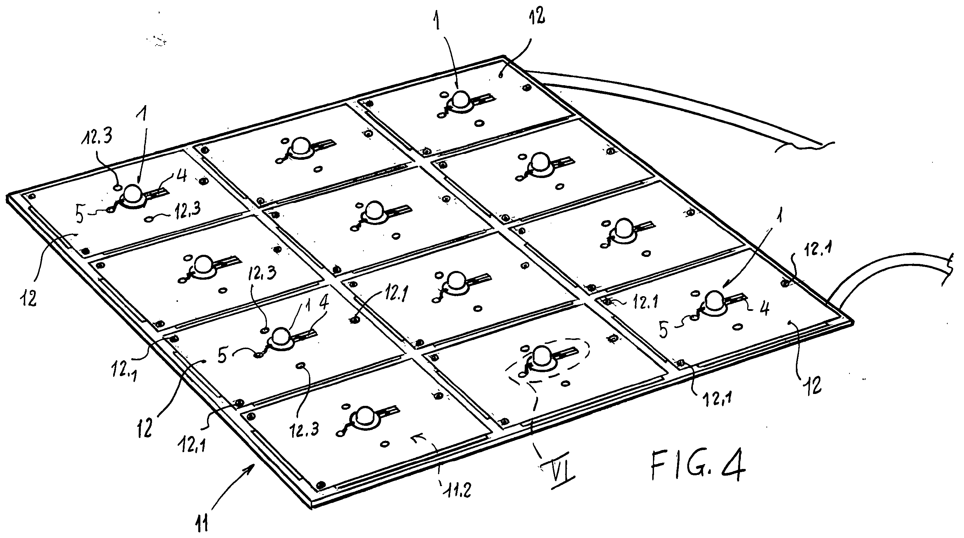

Fig. 4 shows the overall internal structure 10.1 of said LED lamp according to the first embodiment of the invention of Fig. 3, comprising an arrangement of twelve LEDs 1 with the respective individual foil heat sinks 12. It must be noted that a track (not shown) for electrical connection to the cathode of a subsequent cell 11.2, with respective heat sink 12 and LED 1, branches from one of said fixing points 12.1 of a foil heat sink 12. The aforesaid LEDs 1 are connected electrically to one another in series, while each foil heat sink 12 also has a pair of through holes 12.3 arranged on opposite sides of the respective LED 1 and which are used for mounting additional optical means, such as lenses (not shown).

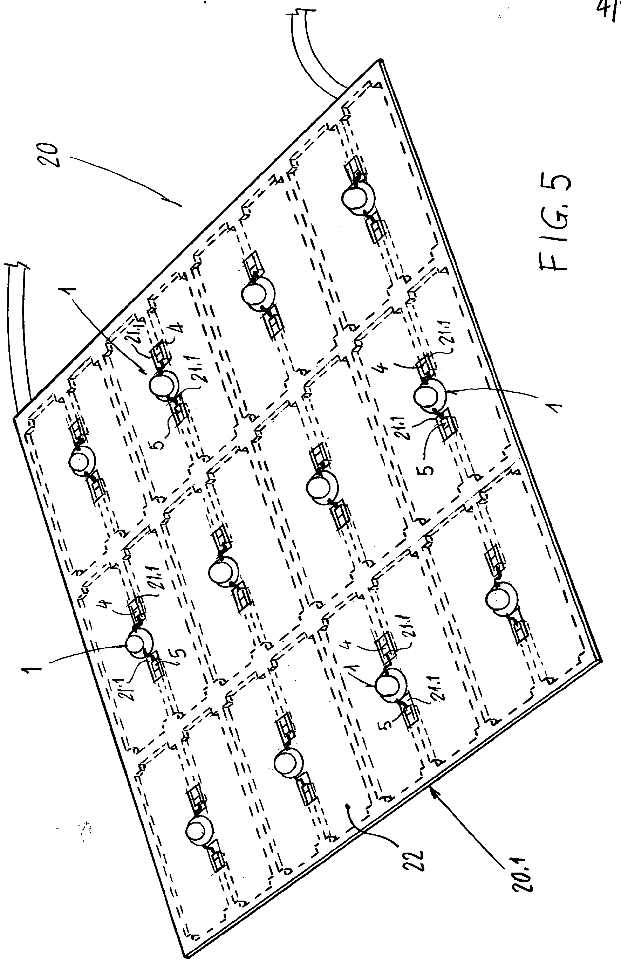

With reference to Figs. 5 and 6 there is shown the internal structure 20 with electronic printed circuit and LED of a LED lamp according to another example of embodiment of the present invention. Also in this case, the respective external containing enclosure is not shown, as it is not of interest for the purposes of the description.

Said internal structure 20 of LED lamp basically comprises:
- an electronic printed circuit 20.1 which is exactly the same as the electronic printed circuit 11 shown and described with reference to Fig. 3 (and therefore not further described here);
- a single quadrangular foil heat sink 22, made of good thermal conductive material, such as copper, which is superimposed to cover said electronic printed circuit 20.1;
- a plurality of power LEDs 1, which are superimposed on said single foil heat sink 22 and arranged in an array according to lines and columns, so that each LED 1 is aligned with a respective open cell of said electronic printed circuit, is connected electrically (by soldering) with its anode 4 and with its cathode 5 directly to the corresponding contacts of said electronic printed circuit 20.1 through corresponding slots 21.1 of said foil heat sink 22, while its thermal pad (not visible in the figure) is soldered on said foil heat sink 22. Therefore, it must be noted that said single foil heat sink 22 is not connected electrically to said electronic printed circuit 20.1.

By means of the aforesaid arrangement, the heat produced by each power LED 1 of the lamp structure 20 is transmitted directly by thermal conduction, in significant amounts, to the single foil heat sink 22 which dissipates it into the surrounding atmosphere through its two free radiant surfaces and through the open cells of said electronic printed circuit 20.1. On the other hand, the support of said electronic printed circuit can, as already stated, also be made of thermally conductive material (CEM-3) and also help to dissipate the residual quantity of heat into the surrounding atmosphere.

The technical form of the external container of said internal structure 20 of the LED lamp according to the invention, which does not fall within the scope of the invention, is such as to favour thermal dispersion of the heat produced by the LEDs 1 and dissipated through the foil heat sink 22 and the support of the electronic printed circuit 20.1.

Fig. 6 shows electrical and mechanical mounting of a LED 1 relative to the electronic printed circuit 20.1 and to the heat sink 22 of said internal structure 20 of LED lamp.

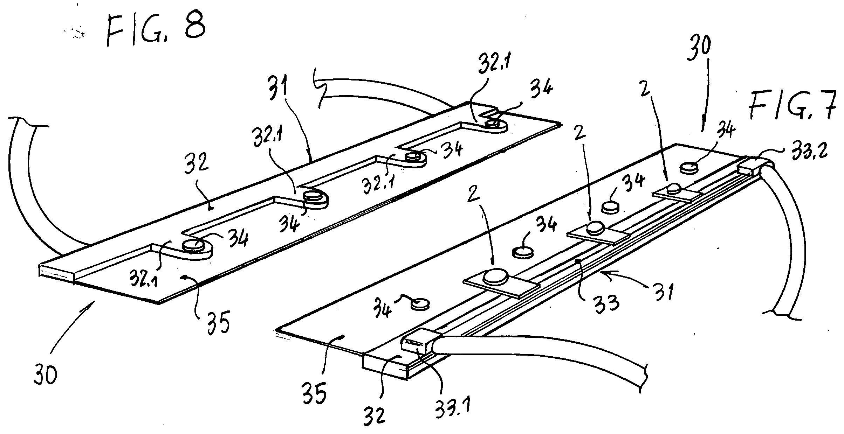

Figs. 7 and 8 show, in a perspective view from the top and from the bottom respectively, the internal structure 30 of a third example of embodiment of the LED lamp according to the invention, comprising an electronic printed circuit 31 of substantially linear type. Said electronic printed circuit 31 includes a support substantially in the form of a rectilinear bar 32 made of electrically insulating material, such as CEM-3 or FR-4, in which there is provided an electrically conductive linear track 33, for example made of copper, which electrically connects, between two end terminals 33.1, 33.2 soldered respectively to two electrical conductors of an electrical power cable, the anode and the cathode of a plurality of power LEDs 2.

Said bar support 32 of said electronic printed circuit 31 has a plurality of integral fins 32.1 projecting from one side thereof at regular intervals, on which there is fixed by means of respective rivets 34 a single foil heat sink 35, for example made of copper, projecting in a cantilever fashion from the bar support 32. The thermal pads of said power LEDs 2 are soldered on said single foil heat sink 35 using a known technique. Naturally, the foil heat sink 35 is fixed on the bar support 32 using rivets 34 prior to mounting of the thermal pads of the LEDs 2 on the foil heat sink 35 by soldering and their respective electrical connection relative to the track 33. In particular, the fins 32.1 are lowered relative to the top of the bar support 32 by a height substantially corresponding to the thickness of foil 35, so that when the same foil is mounted it is flush with the track 3 of the electronic printed circuit 31.

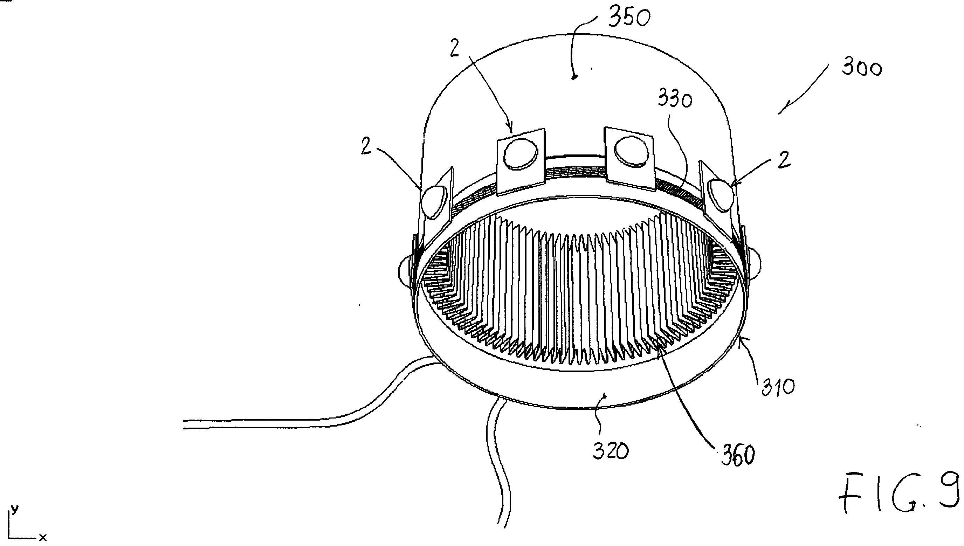

With reference to Fig. 9, the number 300 indicates the internal structure of a fourth example of embodiment of the LED lamp according to the invention, comprising an electronic printed circuit 310 of substantially annular type. Said electronic printed circuit 310 includes a flexible and substantially annular mechanical support 320 made of an electrically insulating material, such as CEM-3 or FR-4, in which there is provided a corresponding electrically conductive circular track 330, for example made of copper, which electrically connects the anode and the cathode of a plurality of power LEDs 2.

A single foil heat sink 350, for example made of copper and with a substantially tubular cylindrical shape, projects coaxially and in a cantilever fashion relative to one side of the annular support 320, to which it is fixed using a known technique (see the description of the previous example). Therefore, it must be noted that said single foil heat sink 350 is shaped in a way corresponding to the geometrical shape of said support 320 of the printed circuit 310.

The thermal pads of said power LEDS 2 are soldered on said single foil heat sink 350, as described with reference to the previous examples of embodiment.

Moreover, on the internal surface of said tubular foil heat sink 350 there is fixed a corresponding auxiliary heat sink device 360, made of a corrugated sheet of copper or a similar good thermal conductive material, ring-shaped, so that the heat produced by the LEDs 2 is dispersed by thermal conduction through said single foil heat sink 350 and said auxiliary heat sink device 360.

In a variant of embodiment of the present invention, not shown, on each foil heat sink there are fixed one or more heat dissipating units (not shown), each comprising for example a foil made of thermally conductive material, such as copper, U-shaped and fixed integrally, for example, to the same foil heat sink so as to be placed in thermal conductive communication with the same foil heat sink. Each heat dissipating unit is fixed to the foil heat sink, for example, by means of soldering of the base branch of the aforesaid U-shaped foil so that the equilateral branches project from the surface of the foil heat sink, in order to provide a very large dissipating surface.

In a further variant of embodiment of the present invention, not shown, each foil heat sink comprises dissipating fins obtained by means of cutting and/or bending of a portion of the same foil heat sink. Said dissipating fins are an integral part of the aforesaid foil heat sink and project from its surface. They enable greater irradiation of the heat produced by the LED or by the LEDs of the lamp according to the invention, improving the air circulation and dissipation properties of said foil heat sink.

The aforesaid foil heat sinks 12, 22, 35, 350 are placed in fluid communication with the external environment by means of openings (generally holes or lamellar shaped openings) provided in the external enclosure (not shown) of the LED lamp according to the invention. In this way, the air coming from the external environment can circulate freely inside the LED lamp and remove the heat produced therein by radiation. Instead, if the LED lamp is to be used in an outdoor environment, the external enclosure is preferably made of a thermal conductive material, such as co-moulded aluminium or copper, so that the heat developed inside the LED lamp can be removed by convection toward the external environment.

Moreover, it must be noted that, as described and shown, the support of the printed circuit can be either rigid or flexible, in order to better adapt to the structural characteristics of the LED lamp (See the example of Fig. 9).

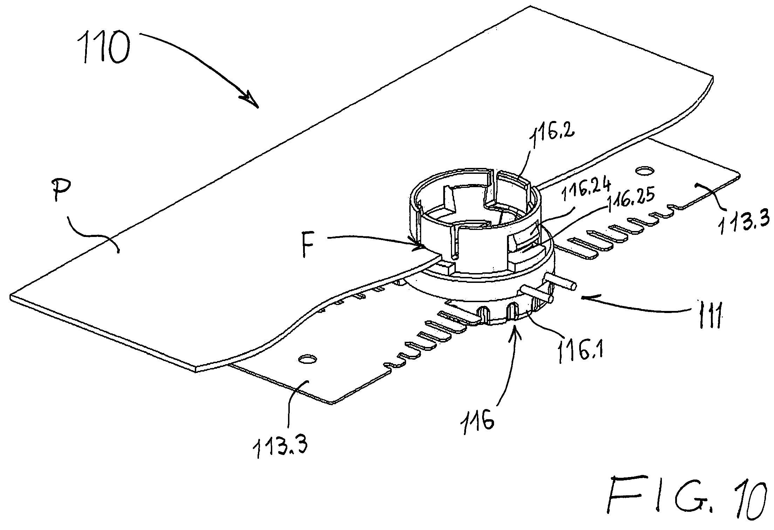

In Fig. 10, the number 110 indicates as a whole the LED lamp according to a fifth example of embodiment of the invention, comprising a mounting plate P, for example made of metal, plastic or glass and represented only partially, and a power LED modular lighting component 111.

In said Fig. 10 a single modular lighting component 111 is shown, which - as will be more apparent below - is mechanically fixed (in a demountable manner) relative to the plate P, for example by means of elastic snap connection in a corresponding hole F of the same plate. However, said lamp 110 can comprise a plurality of said modular lighting components 111, connected electrically to one another and each mechanically fixed to said plate P, for example by means of elastic snap connection in respective holes of the same plate.

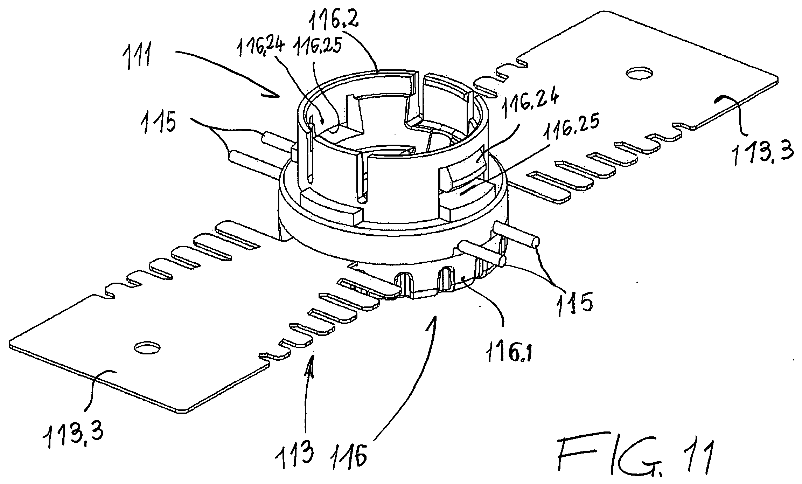

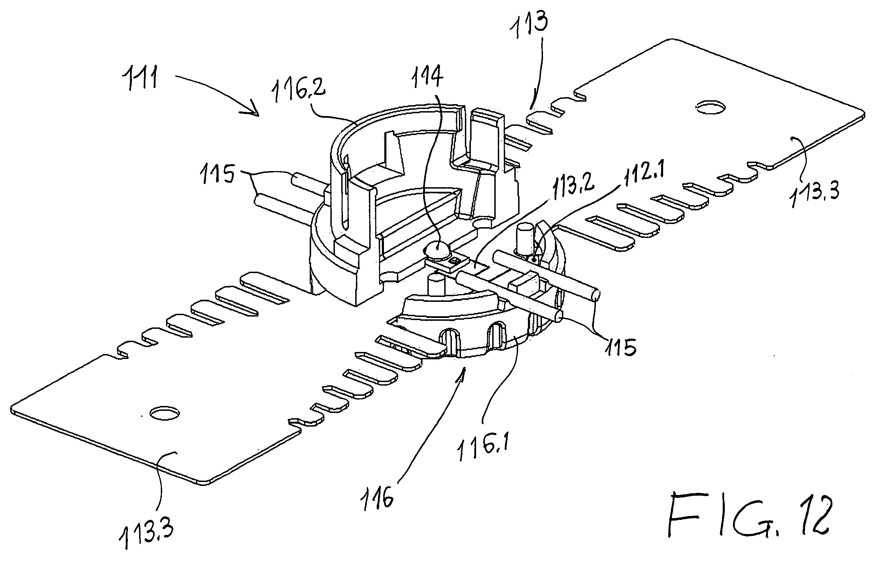

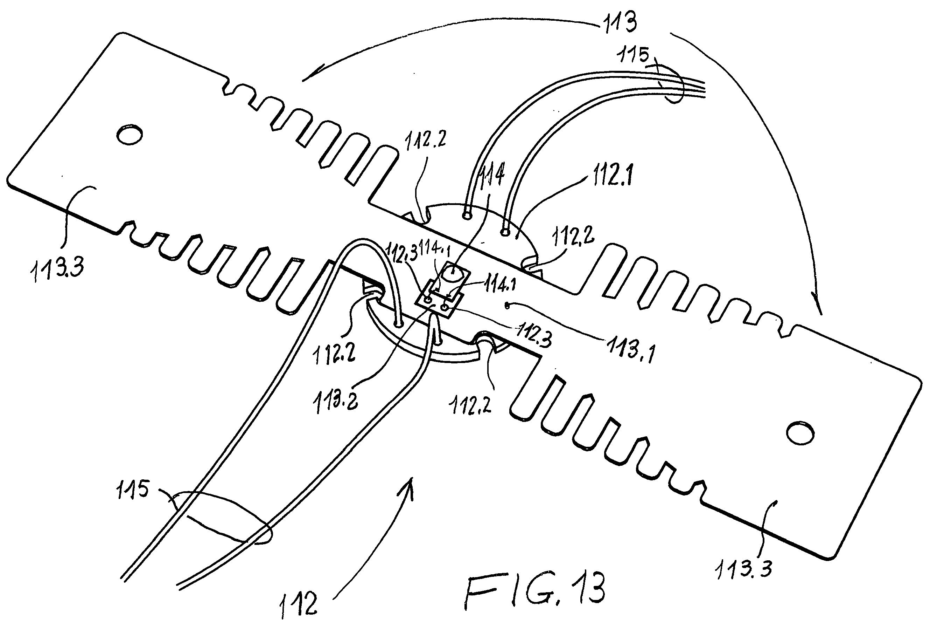

With reference also to Figs. 11 to 15, said modular lighting component 111 comprises a lighting unit 112 (Fig. 13), in which there is provided on a mechanical support 112.1 an electronic printed circuit (known and not shown in detail in the drawing), which conventionally includes electrical tracks, which provide the electrical connection between the various electronic components of said lighting unit. Said mechanical support 112.1 is made of an electrically insulating but thermally conductive material, such as CEM-3, and is structured in the form of a basically circular plate, with four circumferential C-shaped grooves 112.2. Said support 112.1 can also be made, for example, of FR-4, which is not thermally conductive, and have any other shape.

Said lighting unit 112 also comprises a foil heat sink 113, made of good thermal conductive metal material, such as copper. Said heat sink 113 is superimposed and fixed to said support 112.1 of the printed circuit by means of an intermediate and narrow portion thereof 113.1, in which a quadrangular opening 113.2 is provided.

A power LED 114 is superimposed and fixed by means of its thermal pad (not visible in the drawings) to said intermediate portion 113.1 of the heat sink 113. Fixing is obtained, for example, by soldering. Moreover, the LED 114 is connected electrically, by means of the anode and the cathode, to said electronic printed circuit through two electric conductors 114.1 soldered to respective terminals or electrically conductive pads 112.3 of the same circuit, accessible through the opening 113.2.

It must be noted that the area of said foil heat sink 113 which rests on the support 112.1 of the printed circuit, just as the same support if necessary, is roughened and fixed, for example by means of glue or the like, to prevent the solder from coming out during soldering.

Opposite comb-shaped fins 113.3 extend from said intermediate portion 113.1 of the heat sink 113 beyond said support 112.1 of the electrical printed circuit. Said fins 113.3 are free from all contact. Moreover, said fins can have square through holes of dimension greater than or equal to the thickness of the same foil, so as to increase the thermally dissipating surface. Respective flexible isolated electrical conductors 115 are branched at the input and at the output from the anode and from the cathode of said electrical printed circuit.

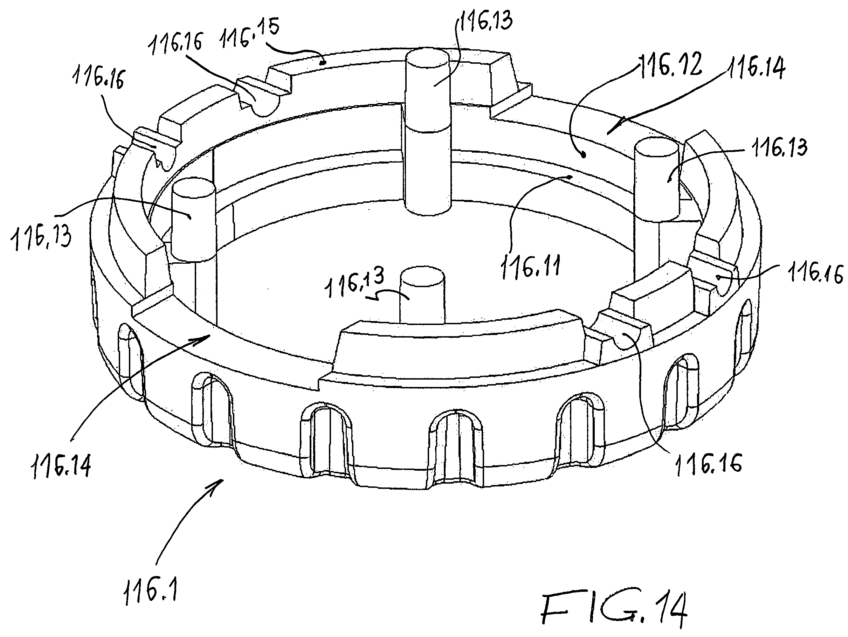

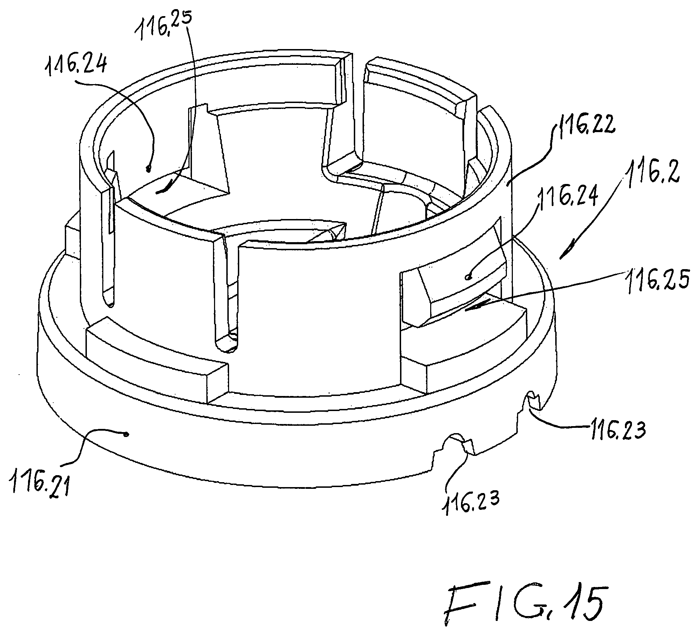

On the other hand, said modular lighting component 111 comprises a modular enclosure 116 (Figs. 10, 11, 12), including two mutually superimposed and coupled parts, respectively a bottom 116.1 (fig. 14) and a cover 116.2 (Fig. 15), for example made of plastic material.

Said bottom 116.1 is substantially annular and comprises an internal circular step 116.11 and an external circular crown 116.12, integral and raised relative to said step 116.11. Said step 116.11 also supports four integral columns or pins 116.13, with axes orthogonal to its circular crown face and staggered from one another substantially by 90°. Said columns 116.13 extend beyond said crown 116.12.

Said circular crown 116.12 has at the top two opposite notches 116.14 and, on the remaining part of the circumference, an interlocking crest 116.15. Two opposite pairs of substantially semi-cylindrical grooves 116.16 interrupt said interlocking crest 116.15.

The cover 116.2 comprises an external annular base 116.21 and an integral crown 116.22, internal and raised relative to said base. Said annular base 116.21 is provided inferiorly with two opposite pairs of substantially semi-cylindrical grooves 116.23 (only two of which are visible in the drawing), which correspond to the semi-cylindrical grooves 116.16 of said bottom 116.1 and is coupled with interlock relative to the crest 116.15 and to the columns 116.13 of said bottom 116.1 of the modular enclosure, so that the pairs of flexible isolated conductors 115 pass through the openings formed by said pairs of opposed grooves 116.16 / 116.23.

Moreover, said cover 116.2 comprises two opposite retaining teeth 116.24, integral but elastically floating relative to the crown 116.22, which have a conical trend tapered towards the free end of said crown, while in proximity of the base 116.21, from which they are slightly spaced, they form a free gap 116.25, to house the plate P. In this way, said elastic teeth 116.24 provide an automatic elastic snap retaining mechanism of the modular lighting component 111 relative to the plate P, when the crown 116.22 of the enclosure 116 is inserted with slight force in a corresponding hole F of said plate, until the base 116.21 is arranged resting against said plate P.

It must be noted that the hole F is standardized in relation to the structure and to the dimensions of said retaining means of the modular enclosure 116.

Moreover, the support 112.1 of the lighting unit 112 with foil heat sink 113 and LED 114 is resting against the internal circular step 116.11 of the bottom 116.1 of the enclosure 116, so that the LED 114 is facing toward the cover 116.2 and the C-shaped grooves 112.2 partially surround the respective columns 116.13 of the bottom. Moreover, the fins 113.3 of the heat sink 113 each extend through a respective notch 116.14 of said bottom 116.1 of the enclosure 116.

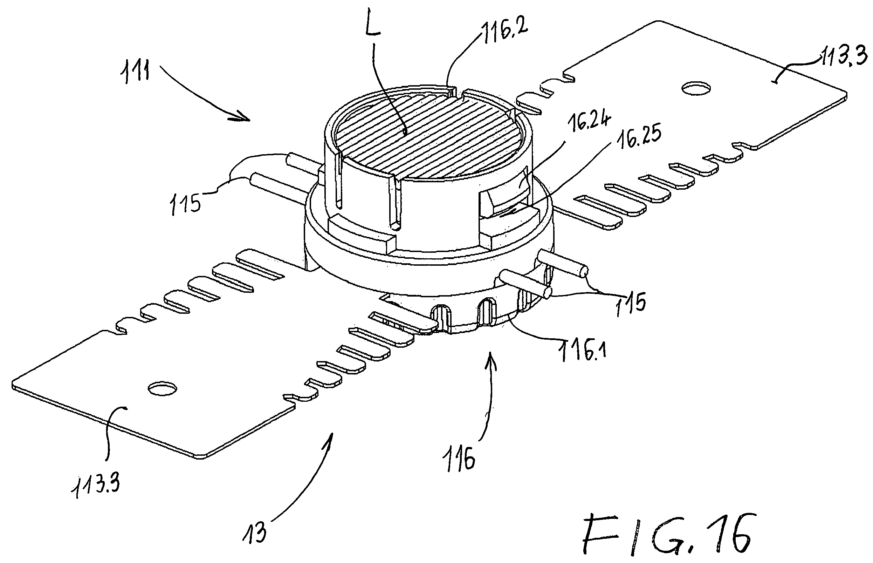

It must be noted that the cover 116.2 is internally perforated to enable passage of the beam of light generated by the LED 114, which is diffused by means of the crown 116.22 of said cover. Moreover, as shown in Fig. 16, the crown 116.22 of said cover 116.2 supports a lens L and thus acts as diffuser and lens-holder of said modular lighting component 111.

The modular enclosure 116 and the lighting unit 112 of the modular lighting component 111 are electrically isolated and made water-resistant by means of an appropriate synthetic resin or the like.

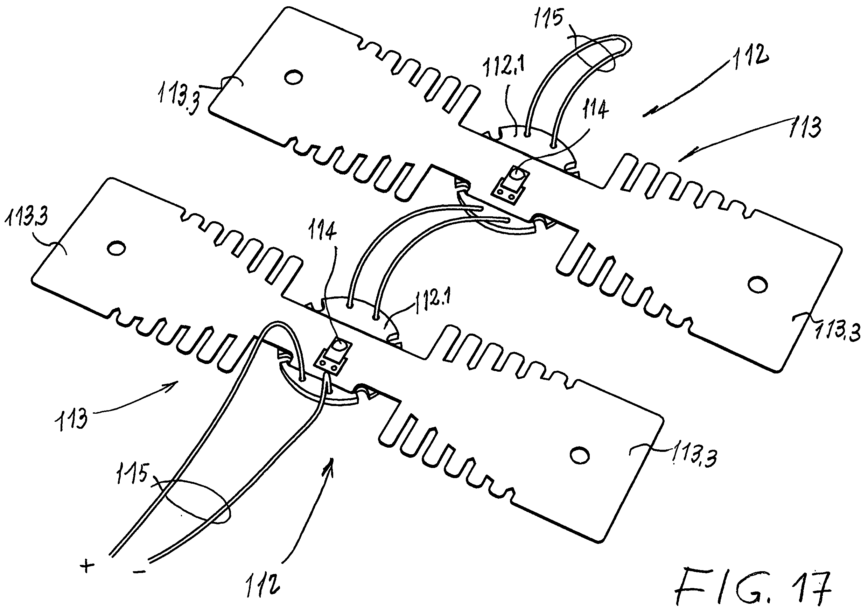

Fig. 17 shows the electrical connection in parallel or in series, according to the printed circuit, of two lighting units 112 which, provided with respective enclosures 116 (not shown for simplification in said figure), form two modular lighting components 111, which can be mounted in a same support plate or the like, to form a LED lamp with a plurality of light sources. This arrangement can be produced with any number of modular lighting components 111 snap mounted in a plate or the like.

Moreover, a single power LED, such as the LED 114 shown here, or a plurality of power LEDs, can be connected electrically in each lighting unit 112 in a manner known *per se.*

On the other hand, in place of the pre-formed and assembled modular enclosure 116, the lighting unit 112 can be incorporated with seal in a modular enclosure produced in a single body by means of moulding of plastic material.

It must be noted that the lighting unit 112 contained in the modular enclosure 116 can also comprise the electronic control means of the operation of the LED or LEDs (known *per se* and not shown), connected electrically to the electronic printed circuit provided on the support 112.1. Said electronic control means can be produced either as a component integrated on said support 112.1 or as a separate electric printed circuit component. In any case, said electronic control means are contained in said modular enclosure 116, which is electrically isolated and water-resistant.

The main advantages of the aforesaid fifth embodiment of the present invention are as follows:

### a) Thermal advantage

As can be understood from the above, the modular enclosure 116 acts as an effective electrical isolator, as seal means against water and atmospheric agents, as dust seal, as light diffuser and, if necessary, as lens-holder by means of its crown 116.22. The same modular enclosure 116 encapsulates, as described above, the lighting unit 112, in an effective manner and without drawbacks, due to the high thermal dissipation capacity of the foil heat sink means 113, whose opposite fins 113.3 extend beyond said support 112.1 of the lighting unit 112 and beyond the corresponding modular enclosure 116. In the absence of said heat sink means 113, thermal stress would soon damage the enclosure 116 and the LED or LEDs, making the modular lighting component 111 unusable.

### b) Productive advantage

The LED modular lighting component 111 of the lamp according to the invention enables the production of a plurality of light points on a simple perforated support, such as a plate or similar made of metal, plastic material, glass or other suitable material, of any shape and dimension, employing the same component in a plurality of exemplars and mounting it with extreme ease or with elastic snap connection or pressure or, in any case, using another fixing method, through a corresponding hole or opening of said support.

### Method for soldering the LEDS on the foil heat sink

The method for soldering the LEDS comprises the following steps:
- identifying a point for positioning said LED or LEDs on the foil heat sink, and applying a low-melting material, for example solder or solder paste, in said point,
- setting a respective LED on top of the low-melting material in the positioning point,
- providing a layer of "solder resist" around the thermal pad of the LED,
- positioning the foil heat sink in a ventilated soldering oven,
- once soldering is completed, removing the foil heat sink from the oven.

A fundamental step of this method is laying of the solder resist around each LED before placing the plate inside the ventilated soldering oven. Said layer of solder resist has the function of preventing the solder or solder paste from coming out of the solder zone of the LED during its stay in the oven; in fact, as the LED is very light, the ventilation present inside the oven, required for equal distribution of the heat throughout the oven, could cause the solder paste to come out from its position, jeopardizing both correct positioning of the LED and transmission of heat during operation of the lamp.

## Claims

1. A LED lamp (110) comprising at least one LED (114), which includes a metal base for dissipation of heat produced during operation, called thermal pad, and two terminals electrically connected to at least one track in an electrically conductive material in a support (112.1) of an electronic printed circuit (11; 20.1; 31; 310), wherein said thermal pad of said at least one LED (114) is connected directly relative to a foil heat dissipator, hereinafter said heat sink (113; 35; 350), made of good thermal conductive material, so as to disperse the heat produced by said at least one LED also through said heat sink (113; 35; 350), which is arranged between said at least one LED (114) and said support (112.1; 11.1; 32; 320) of said printed circuit,
**characterized in that:**
said lamp (110) comprises at least one modular lighting component (111), fixed mechanically relative to a plate (P) and which comprises:
- a lighting unit (112), including:
said support (112.1) of electronic printed circuit,
said foil heat sink (113) superimposed and fixed relative to said support (112.1) of electronic printed circuit,
said at least one LED (114) superimposed and fixed, by means of its thermal pad, relative to said heat sink (113) and connected electrically, by means of the anode and cathode, to said electronic printed circuit, and
- a modular enclosure (116), in which said lighting unit (112) is encapsulated with seal and is electrically isolated,
**and in that** said foil heat sink (113) extends partly beyond said enclosure (116), in a manner free from all contact.

2. The LED lamp according to claim 1, **characterized in that** said modular enclosure (116) comprises retaining means (116.2, 116.22, 116.24, 116.25) for automatic snap fixing in a corresponding seat (F, P) of said support (P).

3. The LED lamp according to one or more of claims 1 and 2, **characterized in that** said foil heat sink (113) comprises at least one fin (113.3) which extends at least partially from said modular enclosure (116).

4. The LED lamp according to one or more of claims 1, 2 and/or 3, **characterized in that** it comprises a plurality of modular lighting components (111), mounted in a same support and forming a LED lamp with a plurality of light sources, wherein a corresponding plurality of lighting units (112), provided with respective modular enclosures (116) fixed to said support, are connected electrically in at least one electrical circuit.

5. The LED lamp according to one or more of claims 1 to 4, **characterized in that** each lighting unit (112) comprises electronic control means of the operation of said at least one LED, which are contained in said modular enclosure (116) and are connected electrically to the electronic printed circuit provided on said support (112.1), are respectively produced as component integrated on said support (112.1) of electronic printed circuit, or are produced as component with separate electric printed circuit.

6. The LED lamp according to one or more of claims 1 to 5, **characterized in that** said foil heat sink (113) comprises at least one fin having at least one through hole of dimension greater than or equal to the thickness of the same foil, so as to increase the thermally dissipating surface.

7. The LED lamp according to Claim 1, **characterized in that** said foil heat sink (35) is substantially coplanar with respect to said support (32) of said printed circuit (31).

8. The LED lamp according to Claim 1, **characterized in that** said foil heat sink (350) is shaped in a way corresponding to the geometrical shape of said support (320) of said printed circuit (310).

9. The LED lamp according to one or more of the preceding claims, comprising a plurality of LEDs (1) electrically connected to at least one track of said printed circuit (11), **characterized in that** each LED (1) is connected to a respective foil heat sink (12).

10. The LED lamp according to one or more of Claims 1 to 8, comprising a plurality of LEDs (1, 2) electrically connected to at least one track of said printed circuit (20.1, 31, 310), **characterized in that** said plurality of LEDs (1, 2) is connected to a common foil heat sink (22, 35, 350).

11. The LED lamp according to one or more of the preceding claims, **characterized in that** said support (11.1) of said printed circuit (11, 20.1) has aeration openings (11.2) to favour circulation of air and thermal dissipation of each foil heat sink (12, 22).

12. The LED lamp according to one or more of the preceding claims, **characterized in that** it comprises a supplementary heat-sink device (360) connected to said foil heat sink (350) to increase thermal dispersion by conduction of the heat produced by said at least one LED or by said plurality of LEDs.

## Patentansprüche

1. Eine LED-Lampe (110), umfassend mindestens eine LED (114), die eine Metall-Basis zur Ableitung der während des Betriebs erzeugten Wärme, das sogenannte Thermal Pad, und zwei Terminals umfasst, die mit mindestens einer Bahn aus elektrisch leitendem Material in einem Träger (112.1) einer elektronischen Leiterplatte (11; 20.1; 31; 310) elektrisch verbunden sind, wobei das Thermal Pad von der mindestens einen LED (114) direkt mit einem laminaren Warmeableiter aus thermal gut leitendem Material, im Folgenden als Heat Sink (113; 35; 350) bezeichnet, so verbunden ist, dass die durch mindestens eine LED erzeugte Wärme auch durch den Heat Sink (113; 35; 350) abgeleitet werden kann, der zwischen der mindestens einen LED (114) und dem Träger (112.1; 11.1; 32; 320) der Leiterplatte angebracht ist,
**dadurch gekennzeichnet, dass:**
die Lampe (110) mindestens ein modulares Beleuchtungs-Bauelement (111) umfasst, mechanisch an einer Platte (P) befestigt, und dass sie Folgendes umfasst:
- eine Beleuchtungseinheit (112), die umfasst:
den Träger (112.1) der elektronischen Leiterplatte,
den laminaren Heat Sink (113), auf dem Träger (112.1) der elektronischen Leiterplatte gelagert und an ihm befestigt,
die mindestens eine LED (114), auf dem Heat Sink (113) mittels ihres Thermal Pads gelagert und an ihm befestigt und mittels der Anode und der Katode mit der elektronischen Leiterplatte elektrisch verbunden, und
- eine modulare Hülle (116), in der die Beleuchtungseinheit (112) dicht eingekapselt und elektrisch isoliert ist,
und **dadurch, dass** der laminare Heat Sink (113) sich zum Teil jenseits der Hülle (116) erstreckt, frei von jeglicher Berührung.

2. Eine LED-Lampe gemäß Anspruch 1, **dadurch gekennzeichnet, dass** die modulare Hülle (116) Haltevorrichtungen (116.2, 116.22, 116.24, 116.25) für die automatische Schnappbefestigung in einem entsprechenden Sitz (F, P) des Trägers (P) umfasst.

3. Eine LED-Lampe gemäß einem oder mehreren der Ansprüche 1 und 2, **dadurch grekennzeichnet, dass** der laminare Heat Sink (113) mindestens einen Flügel (113.3) umfasst, der sich zumindest teilweise von der modularen Hülle (116) aus ausstreckt.

4. Eine LED-Lampe gemäß einem oder mehreren der Ansprüche 1, 2 und/oder 3, **dadurch gekennzeichnet, dass** sie eine Mehrzahl von modularen Beleuchtungs-Bauelementen (111) umfasst, die auf einem gleichen Träger montiert sind und eine LED-Lampe mit mehreren Leuchtquellen bilden, wobei eine entsprechende Mehrzahl von Beleuchtungseinheiten (112), verstehen mit den entsprechenden modularen Hüllen (116), die an dem Träger befestigt sind, in mindestens einem elektrischen Kreislauf elektrisch verbunden sind.

5. Eine LED-Lampe gemäß einem oder mehreren der Ansprüche von 1 bis 4, **dadurch gekennzeichnet, dass** jede Beleuchtungseinheit (112) elektronische Vorrichtungen zur Funktionskontrolle von mindestens einer LED umfasst, die sich in der modularen Hülle (116) befinden und elektrisch verbunden sind mit der elektronischen Leiterplatte, die sich auf dem Träger (112.1) befindet, und sie sind jeweils als Komponente realisiert, die auf dem Träger (112.1) der elektronischen Leiterplatte integriert ist, oder sie sind als Komponente mit getrennt elektronischer Leiterplatte realisiert.

6. Eine LED-Lampe gemäß einem oder mehreren der Ansprüche von 1 bis 5, **dadurch gekennzeichnet, dass** der laminare Heat Sink (113) mindestens einen Flügel umfasst, der mindestens ein durchgehendes Loch aufweist mit Durchmesser größer oder gleich der Dicke des Flügels selbst, sodass die thermische Ableitungsflache vergrößert wird.

7. Eine LED-Lampe gemäß Anspruch 1, **dadurch gekennzeichnet, dass** der laminare Heat Sink (35) im Wesentlichen komplanar ist mit dem Träger (32) der elektronischen Leiterplatte (31).

8. Eine LED-Lampe gemäß Anspruch 1, **dadurch gekennzeichnet, dass** der laminare Heat Sink (350) angepasst ist zur entsprechenden geometrischen Form des Trägers (320) der elektronischen Leiterplatte (310).

9. Eine LED-Lampe gemäß einem oder mehreren der vorhergehenden Ansprüche, umfassend eine Mehrzahl von LEDs (1), die elektrisch mit mindestens einer Bahn der Leiterplatte (11) verbunden ist, **dadurch gekennzeichnet, dass** jede LED (1) mit einem entsprechenden laminaren Heat Sink (12) verbunden ist.

10. Eine LED-Lampe gemäß einem oder mehreren der Ansprüche von 1 bis 8, umfassend eine Mehrzahl von LEDs (1, 2), die elektrisch mit mindestens einer Bahn der Leiterplatte (20, 1, 31, 310) verbunden ist, **dadurch gekennzeichnet, dass** die Mehrzahl von LEDs (1, 2) mit einem gewöhnlichen laminaren Heat Sink (22, 35, 350) verbunden ist.

11. Eine LED-Lampe gemäß einem oder mehreren der vorhergehenden Ansprüche, **dadurch gekennzeichnet, dass** der Träger (11.1) der Leiterplatte (11, 20.1) Lüftungsöffnungen (11.2) aufweist, die die Luftzirkulation und die Wärmeableitung jedes laminaren Heat Sinks (12, 22) fördern.

12. Eine LED-Lampe gemäß einem oder mehreren der vorhergehenden Ansprüche, **dadurch gekennzeichnet, dass** sie eine zusätzliche Heat-Sink-Vorrichtung (360) umfasst, verbunden mit dem laminaren Heat Sink (350), um die Wärmeableitung durch Ableitung der Wärme zu erhöhen, die durch die mindestens eine LED, beziehungsweise durch die Mehrzahl von LEDs erzeugt wird.

## Revendications

1. Lampe à DEL (110) comprenant au moins une DEL (114), laquelle inclut une base métallique de dissipation de la chaleur produite durant le fonctionnement, appelé thermal pad, et deux bornes raccordées électriquement à au moins une piste en matériau conduisant l'électricité dans un support (112.1) d'un circuit électronique imprimé (11 ; 20.1 ; 31 ; 310), où ledit thermal pad de ladite au moins une DEL (114) est directement raccordée par rapport à un dissipateur de chaleur à lamelle, appelé ci-après heat sink (113 ; 35 ; 350), en matériau bon conducteur thermique, afin de dissiper également la chaleur produite par ladite au moins une DEL aussi à travers ledit heat sink (113 ; 35 ; 350), lequel est disposé entre ladite au moins une DEL (114) et ledit support (112.1 ; 11.1 ; 32 ; 320) dudit circuit imprimé,
**caractérisée en ce que :**
ladite lampe (110) comprend au moins un composant modulaire d'éclairage (111), fixé mécaniquement par rapport à une plaque (P) et qui comprend :
- une unité d'éclairage (112), incluant :
ledit support (112.1) de circuit électronique imprimé,
ledit heat sink à lamelle (113) superposé et fixé par rapport audit support (112.1) de circuit électronique imprimé,
ladite au moins une DEL (114) superposée et fixée, à l'aide de son thermal pad, par rapport audit heat sink (113) et raccordée électriquement, au moyen de l'anode et de la cathode, audit circuit électronique imprimé, et
- une enveloppe modulaire (116), dans laquelle ladite unité d'éclairage (112) est encapsulée de manière étanche et est isolée électriquement,
**et en ce que** ledit heat sink à lamelle (113) s'étend en partie au-delà de ladite enveloppe (116), de manière libre de tout contact.

2. Lampe à DEL selon la revendication 1, **caractérisée en ce que** ladite enveloppe modulaire (116) comprend des moyens de retenue (116.2, 116.22, 116.24, 116.25) pour la fixation automatique par clipsage dans un logement correspondant (F, P) dudit support (P).

3. Lampe à DEL selon une ou plusieurs des revendications 1 et 2, **caractérisée en ce que** ledit heat sink à lamelle (113) comprend au moins une ailette (113.3) qui s'étend au moins partiellement à partir de ladite enveloppe modulaire (116).

4. Lampe à DEL selon une ou plusieurs des revendications 1, 2 et/ou 3, **caractérisée en ce qu'elle** comprend une pluralité de composants modulaires d'éclairage (111), montés dans un même support et formant une lampe à DEL à plusieurs sources lumineuses, dans laquelle une pluralité correspondante d'unités d'éclairage (112), dotées d'enveloppes modulaires (116) respectives fixées audit support, sont raccordées électriquement à au moins un circuit électrique.

5. Lampe à DEL selon une ou plusieurs des revendications 1 à 4, **caractérisée en ce que** chacune des unités d'éclairage (112) comprend des moyens électroniques de contrôle du fonctionnement de ladite au moins une DEL, lesquels sont contenus dans ladite enveloppe modulaire (116) et sont raccordés électriquement au circuit électronique imprimé prévu sur ledit support (112.1), sont respectivement réalisés comme composant intégré sur ledit support (112.1) de circuit électronique imprimé, ou sont réalisés comme composant à circuit électrique imprimé séparé.

6. Lampe à DEL selon une ou plusieurs des revendications 1 à 5, **caractérisée en ce que** ledit heat sink à lamelle (113) comprend au moins une ailette qui présente au moins un trou passant de dimensions supérieures ou égales à l'épaisseur de la lamelle, afin d'augmenter la surface de dissipation thermique.

7. Lampe à DEL selon la revendication 1, **caractérisée en ce que** ledit heat sink à lamelle (35) est substantiellement coplanaire par rapport audit support (32) dudit circuit imprimé (31).

8. Lampe à DEL selon la revendication 1, **caractérisée en ce que** ledit heat sink à lamelle (350) est conformé de manière correspondante à la forme géométrique dudit support (320) dudit circuit imprimé (310).

9. Lampe à DEL selon une ou plusieurs des revendications précédentes, comprenant une pluralité de DEL (1) raccordées électriquement avec au moins une piste dudit circuit imprimé (11), **caractérisée en ce que** chaque DEL (1) est raccordée à un heat sink à lamelle (12) correspondant.

10. Lampe à DEL selon une ou plusieurs des revendications 1 à 8, comprenant une pluralité de DEL (1, 2) raccordées électriquement avec au moins une piste dudit circuit imprimé (20.1, 31, 310), **caractérisée en ce que** ladite pluralité de DEL (1, 2) est raccordée à un heat sink à lamelle commune (22, 35, 350).

11. Lampe à DEL selon une ou plusieurs des revendications précédentes, **caractérisée en ce que** ledit support (11.1) dudit circuit imprimé (11, 20.1) présente des ouvertures d'aération (11.2) pour favoriser la circulation d'air et la dissipation thermique de chaque heat sink à lamelle (12, 22).

12. Lampe à DEL selon une ou plusieurs des revendications précédentes, **caractérisée en ce qu'elle** comprend un dispositif supplémentaire heat sink (360) raccordé audit heat sink à lamelle (350) pour augmenter la dissipation thermique par conduction de la chaleur produit par ladite au moins une DEL ou par ladite multitude de DEL respectivement.
